# EUROPEAN PATENT SPECIFICATION

(11) **EP 4 616 476 B1**
(45) Date of publication and mention of the grant of the patent: **01.07.2026**
(21) Application number: 23800765.2
(22) Date of filing: 31.10.2023
(51) Int. Cl.: H01M 50/213, H01M 50/519, H01M 10/42, H05K 1/189

(54) **BATTERY COMPARTMENT ASSEMBLIES FOR PATIENT MONITORS**
BATTERIEFACHANORDNUNGEN FÜR PATIENTENMONITORE
ENSEMBLES COMPARTIMENTS DE BATTERIE POUR MONITEURS DE PATIENT

(30) Priority: 09.11.2022 US 202263423916 P
(43) Date of publication of application: 17.09.2025
(73) Proprietor: Koninklijke Philips N.V., 5656 AE Eindhoven (NL)
(72) Inventor: MAKIE, Francis, 5656 AG Eindhoven (NL)
(74) Representative: Philips Intellectual Property & Standards
(86) International application number: PCT/EP2023/080295
(87) International publication number: WO 2024/099817

(56) References cited:
- EP-B1- 2 668 682
- JP-A- H0 997 599
- US-A- 5 250 371
- US-B1- 6 733 919
- US-B2- 11 134 565
- US-B2- 8 273 471

## Description

### Field of the Disclosure

The present disclosure relates generally to battery compartment assemblies having a flexible circuit spring member, and more specifically to patient monitors including battery compartment assemblies with features extending the life cycle thereof.

### Background

Removable batteries are used in numerous electronic devices. A battery compartment or adapter is often provided as an interface between one or more batteries and the electronic device that the one or more batteries power. To make electrical contact with the batteries, known battery compartments provide metal spring contacts for interfacing with the batteries. Metal spring contacts can provide long-lasting electrical connected with the batteries over numerous cycles of removing and replacing the batteries. However, in medical applications, there are a number of drawbacks to using metal spring contacts. For example, metal spring contacts are bulky and add unnecessary expense, can entrap debris and be difficult to sterilize, have exposed areas that increase the likelihood of electrical shocks, and could cause failures in sensitive electronic components such as patient monitors, respirators, and the like. EP2668682A1 discloses a battery adapter and method of making the same.

### Summary of the Disclosure

According to an embodiment of the present disclosure, a battery compartment assembly is provided. The battery compartment assembly comprises: a compartment casing having one or more sidewalls that define a receiving area sized to receive one or more removable batteries; a flexible circuit disposed within the receiving area of the compartment casing and having a folded section that is folded at a first sidewall and within the receiving area of the compartment casing, wherein the flexible circuit further comprises one or more conductive strips disposed on the folded section of the flexible circuit; and a resilient spring member disposed between the first sidewall of the compartment casing and the flexible circuit, the resilient spring member comprising one or more hollow cavities offset from each of the one or more conductive strips of the flexible circuit, wherein each hollow cavity is defined between the resilient spring member and the first sidewall of the compartment casing.

In an aspect, each of the one or more conductive strips of the folded section of the flexible circuit provides a battery contact corresponding to one of the removable batteries.

In an aspect, the resilient spring member comprises a recess and a sealing bead circumscribing the recess, the recess being defined between the resilient spring member and the first sidewall of the compartment casing, and the sealing bead being configured to provide a continuous contact with an interior surface of the first sidewall of the compartment casing.

In an aspect, the one or more hollow cavities are disposed within the recess of the resilient spring member.

In an aspect, the resilient spring member comprises a reinforced section within the recess adjacent to at least one of the one or more conductive strips of the flexible circuit.

In an aspect, the sealing bead, the resilient spring member, and the first sidewall of the compartment casing forms an air chamber adjacent to the interior surface of the first sidewall of the compartment casing.

In an aspect, the flexible circuit comprises a non-conductive section between each conductive strip of the flexible circuit, each non-conductive section having a width of at least about 2.0 millimeters.

In an aspect, each hollow cavity of the resilient spring member is adjacent to a non-conductive section of the flexible circuit.

In an aspect, each non-conductive section of the flexible circuit comprises a non-conductive composition.

In an aspect, each non-conductive section of the flexible circuit comprises a polyamide composition.

In an aspect, each hollow cavity of the resilient spring member has a concave surface defining the hollow cavity.

In an aspect, the resilient spring member is secured between the first sidewall of the compartment casing and the folded section of the flexible circuit by a shroud member.

In an aspect, the shroud member comprises one or more latches configured to join the shroud member to the flexible circuit, the resilient spring member, and the compartment casing.

In an aspect, the compartment casing is formed from a rigid material, and the resilient spring member is formed from at least a compressible polymer.

According to another embodiment of the present disclosure, a worn patient monitor is provided. The worn patient monitor comprises: a battery compartment assembly, the battery compartment assembly providing one or more battery contacts configured to interface with the electrical terminals of one or more removable batteries. According to this embodiment, the battery compartment assembly comprises: a compartment casing having one or more sidewalls that define a receiving area sized to receive one or more removable batteries; a flexible circuit disposed within the receiving area of the compartment casing and having a folded section that is folded at a first sidewall and within the receiving area of the compartment casing, wherein the flexible circuit further comprises one or more conductive strips disposed on the folded section of the flexible circuit; and a resilient spring member disposed between the first sidewall of the compartment casing and the flexible circuit, the resilient spring member comprising one or more hollow cavities offset from each of the one or more conductive strips of the flexible circuit, wherein each hollow cavity is defined between the resilient spring member and the first sidewall of the compartment casing.

These and other aspects of the various embodiments will be apparent from and elucidated with reference to the embodiments described hereinafter.

### Brief Description of the Drawings

In the drawings, like reference characters generally refer to the same parts throughout the different views. Also, the drawings are not necessarily to scale, emphasis instead generally being placed upon illustrating the principles of the various embodiments.
FIG. 1 is an exploded view of a battery compartment assembly illustrated according to aspects of the present disclosure.
FIG. 2A is first perspective view a compartment casing illustrated according to aspects of the present disclosure.
FIG. 2B is second perspective view a compartment casing illustrated according to aspects of the present disclosure.
FIG. 3 is a flexible circuit in a folded configuration illustrated according to aspects of the present disclosure.
FIG. 4 is a flexible circuit in a flattened configuration illustrated according to aspects of the present disclosure.
FIG. 5 is a perspective view of a folded flexible circuit and associated resilient spring member illustrated according to aspects of the present disclosure.
FIG. 6 is a perspective view of a resilient spring member illustrated according to aspects of the present disclosure.
FIG. 7 is a cross-sectional perspective view of a resilient spring member illustrated according to aspects of the present disclosure.
FIG. 8 is a shroud member illustrated according to aspects of the present disclosure.
FIG. 9A is a front plan view of a worn patient monitor illustrated according to aspects of the present disclosure.
FIG. 9B is a side plan view of a worn patient monitor illustrated according to aspects of the present disclosure.

### Detailed Description of Embodiments

According to the present disclosure, battery compartment assemblies having a flexible circuit spring member are provided. Also provided herein are patient worn monitors including such battery compartment assemblies that have features extending the life cycle thereof. As described herein, the battery compartment assemblies are configured to provide one or more battery contacts that contact and/or otherwise engage a terminal of a removable battery when the battery is inserted into the battery compartment assembly. These battery terminals cause the battery contacts to flex, thereby creating wear in the flexible circuit, as well as the resilient spring member, every time that the battery is inserted, removed, and/or replaced. According to the present disclosure, it has been found that using various combinations of air chambers, hollow cavities, and/or reinforced sections as described herein can drastically improve the durability and expected life of the battery contacts of the battery compartment assembly. Furthermore, it has been found that the cavities and/or other features described herein can be tuned to balance the otherwise unequal battery forces due to the linear distribution of the batteries, thereby making the process of inserting and/or removing batteries easier and more consistent for the user.

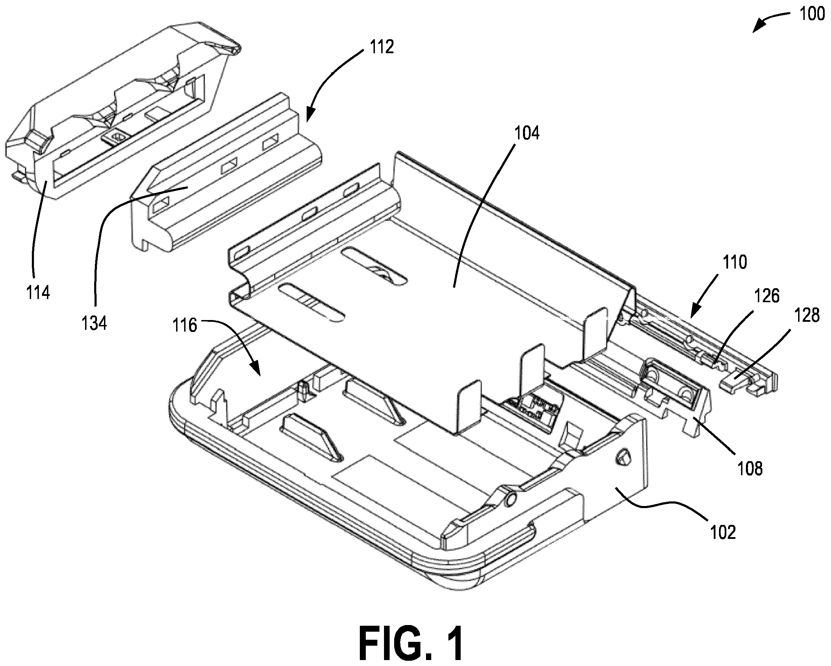

Turning to FIG. 1, an exploded view of a battery compartment assembly 100 is illustrated according to aspects of the present disclosure. According to the present disclosure, the battery compartment assembly 100 includes at least a compartment casing 102, a flexible circuit 104, and a resilient spring member 112. In further embodiments, the battery compartment assembly 100 can include a shroud member 114. In yet further embodiments, the battery compartment assembly 100 may also include a second resilient spring member 108 and/or a bumper member 110.

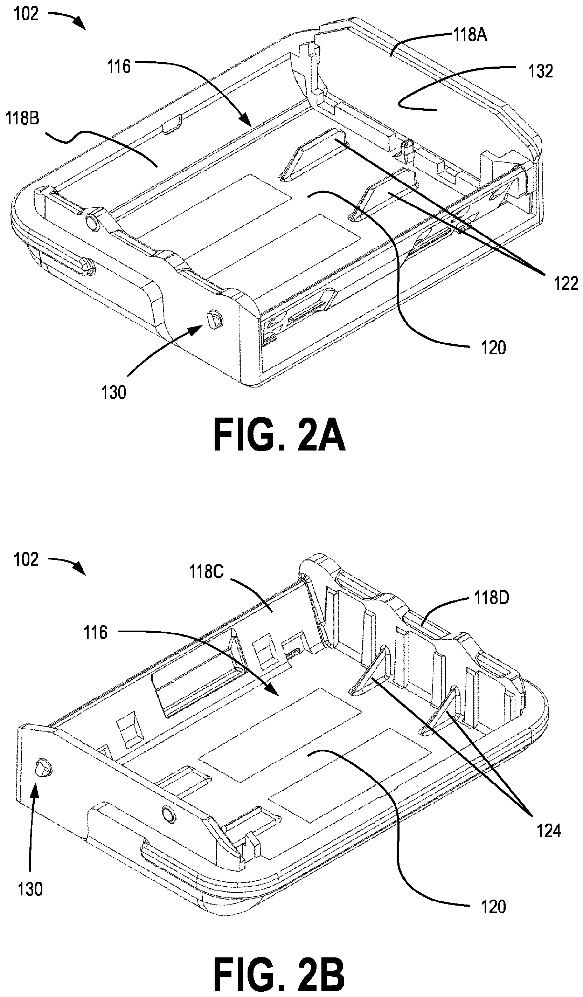

In embodiments, the compartment casing 102 of the battery compartment assembly 100 includes one or more sidewalls that define a receiving area 116 sized to receive one or more removable batteries. As shown in FIG. 2A and FIG. 2B, the battery compartment assembly 100 may be a battery door assembly 100 with a compartment casing 102 that includes sidewalls 118A, 118B, 118C, 118D and a floor (i.e., a backing) 120. The sidewalls 118A, 118B, 118C, 118D and floor 120 may define the receiving area 116 such that the receiving area 116 is configured to receive one or more batteries, including but not limited to, one or more AA batteries, AAA batteries, and/or rechargeable batteries. The batteries (not shown) may preferably extend longitudinally between sidewall 118A and sidewall 118D. In some embodiments, sidewalls 118A, 118B, 118C, 118D and a floor 120 may include one or more spacers 122, 124 to space the batteries.

In embodiments, the compartment casing 102 of the battery compartment assembly 100 may be formed from a rigid material, such as a medical-grade thermoplastic polymer having high impact resistance and resistance to chemical, and a low moisture absorption. In particular embodiments, the compartment casing 102 of the battery compartment assembly 100 can comprise a medical-grade polycarbonate, polypropylene, polyethylene, and the like, and/or combinations thereof.

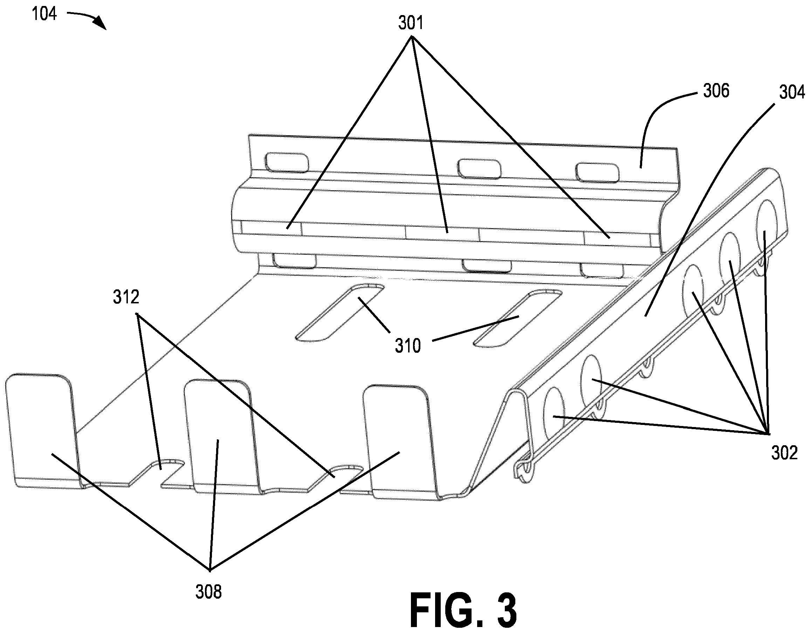

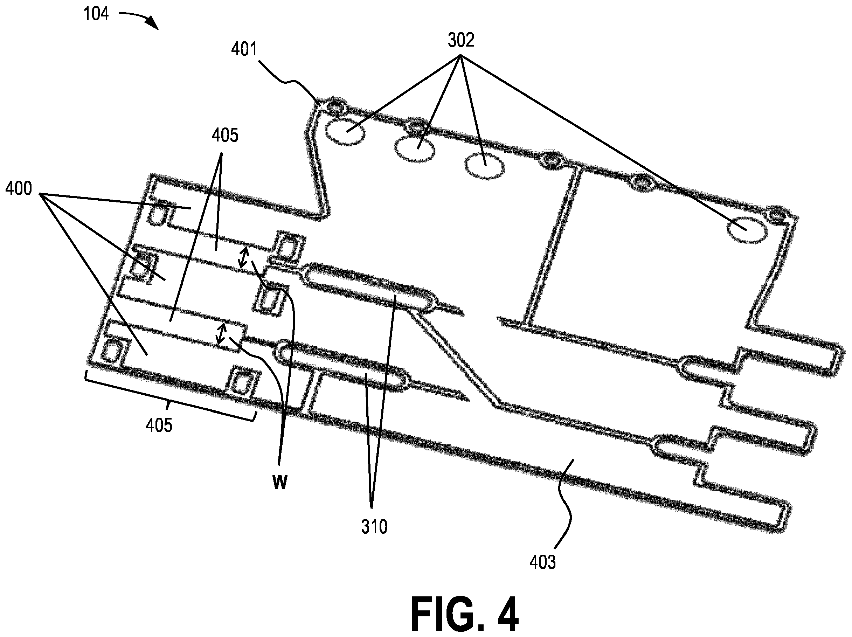

Turning to FIG. 1 and FIG. 3, a flexible circuit 104 of the battery compartment assembly 100 may extend over the compartment casing 102 and into the interior thereof. The flexible circuit 104 may include one or more alignment cutouts 310, 312 that align the flexible circuit 104 with alignment projections of the compartment casing 102. In embodiments, the flexible circuit 104 connects the batteries to an associated electronic device. For example, the flexible circuit 104 can include conductive tracings (i.e., electrical circuits) that connect the batteries and provide power to the associated electronic device. In embodiments, the flexible circuit 104 may provide one or more conductive strips (i.e., sections 400 shown in FIG. 4) configured to contact a terminal of a corresponding removable battery, thereby forming one or more battery contacts 301 to communicate power to the associated electronic device. The flexible circuit 104 may include one conductive strip 400 or may include multiple conductive strips 400 (e.g., two, three, or more than three, etc.). In the example of FIG. 3, the flexible circuit 104 includes at least three conductive strips 400.

In further embodiments, the flexible circuit 104 supplies power from the one or more removable batteries through the one or more conductive strips 400 to the associated electronic device via one or more conductive pads 302. In some embodiments, the flexible circuit 104 of the battery compartment assembly 100 may include at least one conductive pad 302, or may include a plurality of conductive pads 302. As shown in FIG. 3, the flexible circuit 104 of the battery compartment assembly 100 includes five conductive pads 302.

With reference to FIG. 4, a flattened or unfolded flexible circuit 104 is illustrated according to aspects of the present disclosure. In embodiments, the flexible circuit 104 can include a flexible substrate 401 with one or more elastically conductive strips 400 defining one or more battery contacts 301. Conductive tracings 403 may extend through the interior and/or along a rear surface of the flexible circuit 104. In some embodiments, the flexible circuit 104 may be formed from multiple layers, including but not limited to, one or more insulating layers, one or more conductive layers, and the like.

In embodiments, the one or more conductive tracings / layers 403 can be etched to define the conductive strips 400 and/or conductive pads 302. The conductive layers 403 are suitably gold, copper, or the like. As described herein, the conductive traces interconnect the plurality of conductive strips 400 and the batteries to provide power in the form of electricity. In further embodiments, the conductive strips 400 and/or the conductive pads 302 may be plated onto or snap into the flexible circuit 104 to form one or more battery contacts 301 or power contacts 302. For example, the conductive strips 400 and/or conductive pads 302 may be plated with a conducting material, such as a gold material.

Insulating layers are suitably placed around and, if appropriate, between the conductive layers, such that only the conductive strips 400 and/or conductive pads 302 are exposed. In embodiments, for example, the flexible circuit 104 can include one or more non-conductive sections 405 between one or more of the conductive strips 400. In some embodiments, each non-conductive section 405 can have a width (W) of at least about 1 mm, including from about 1 mm to about 5 mm, from about 2 mm to about 4 mm, from about 3 mm to about 4 mm, and/or combinations thereof. The insulating layers and/or non-conductive sections 405 are suitably formed from a polymeric material, such as a polyamide polymer.

An adhesive layer on or applied to the rear surface of the flexible circuit 104 may adhere the flexible circuit 104 to the floor 120 of the compartment casing 102, along the exterior of the compartment casing 102, around the top edge of the sidewalls 118A, 118B, 118C, 118D, and/or along the interior of the sidewalls 118A, 118B, 118C, 118D. In embodiments, the adhesive may be selected to provide a fluid tight seal between the flexible circuit 104 and the compartment casing 102 to prevent microbes from getting between the compartment casing 102 and the flexible circuit 104. The adhesive may be selected to be resistant to chemical disinfectants. In other embodiments, alternative and/or additional techniques such as solvent welding, thermal bonding, and the like may be used.

As mentioned above, the flexible circuit 104 of the battery compartment assembly 100 may be folded over the exterior of the compartment casing 102 and extend into the receiving area 116 of the compartment casing 102. For example, as shown in FIG. 3, the flexible circuit 104 of the battery compartment assembly 100 can include a folded section 304 that is to be folded over at least one sidewall 118C of the compartment casing 102.

In further embodiments, the flexible circuit 104 may further include one or more additional folded sections, such as folded sections 306, 308. The folded sections 304, 306 can be configured to contact the terminals of the one or more batteries and provide power to an associated electronic device through the tracings and conductive areas 301, 302 of the flexible circuit 104. In particular embodiments, each of the conductive strips 400 may be suitably disposed on a common side of the flexible circuit 104 such that the conductive strips 400 are exposed on an interior of the folded section 304 of the flexible circuit 104.

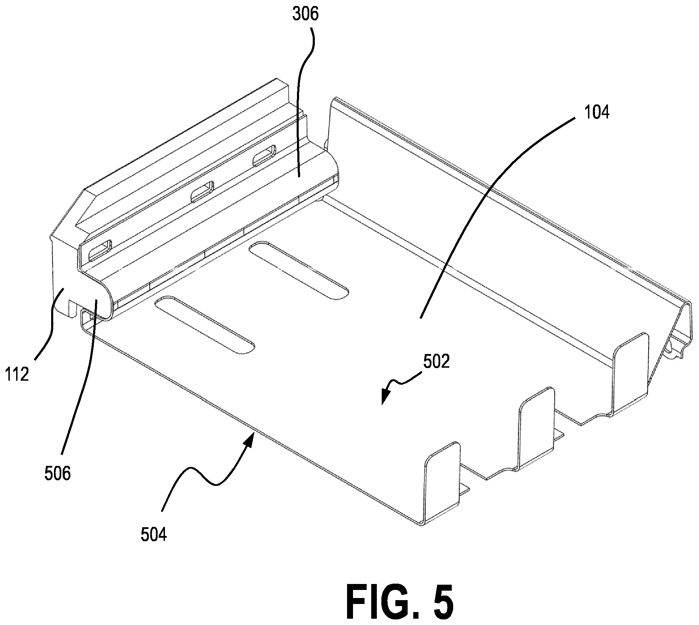

As mentioned above, the battery compartment assembly 100 includes a resilient spring member 112 disposed between a sidewall 118A of the compartment casing 102 and an outward-facing surface of the flexible circuit 104. For example, the position of the flexible circuit 104 relative to the resilient spring member 112 is illustrated in FIG. 5 according to aspects of the present disclosure. As shown, the flexible circuit 104 includes a first surface 502, a second surface 504, and a folded section 306. In embodiments, the resilient spring member 112 includes a rib 506 that extends from a surface 134 of the resilient spring member 112 (shown in FIG. 1) and that follows the contours of the folded section 306 of the flexible circuit 104. In embodiments, the flexible circuit 104 can be disposed within the receiving area 116 of the compartment casing 102 such that the first surface 502 of the flexible circuit 104 faces inwardly toward the open volume of the receiving area 116, while the second surface 504 of the flexible circuit 104 faces outwards towards the compartment casing 102 itself.

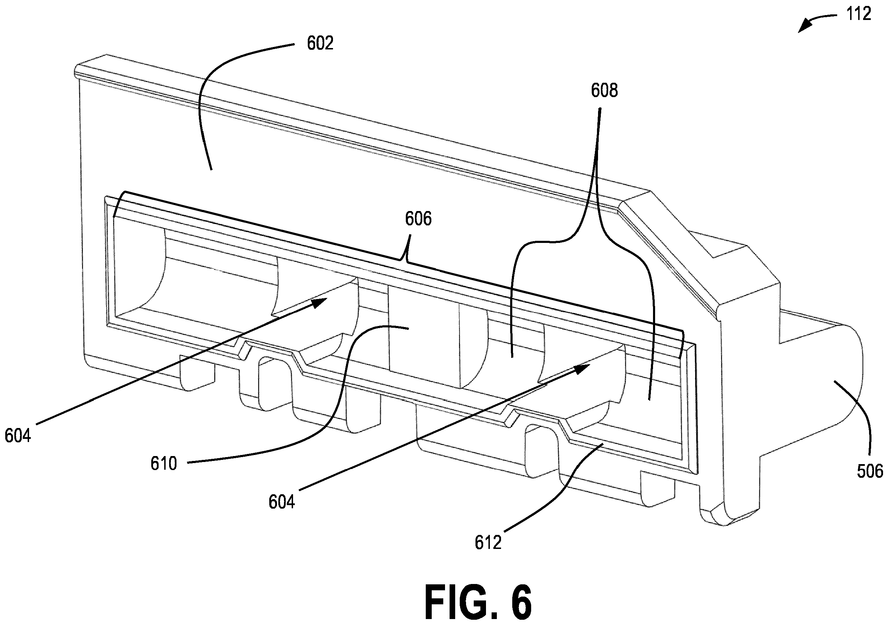

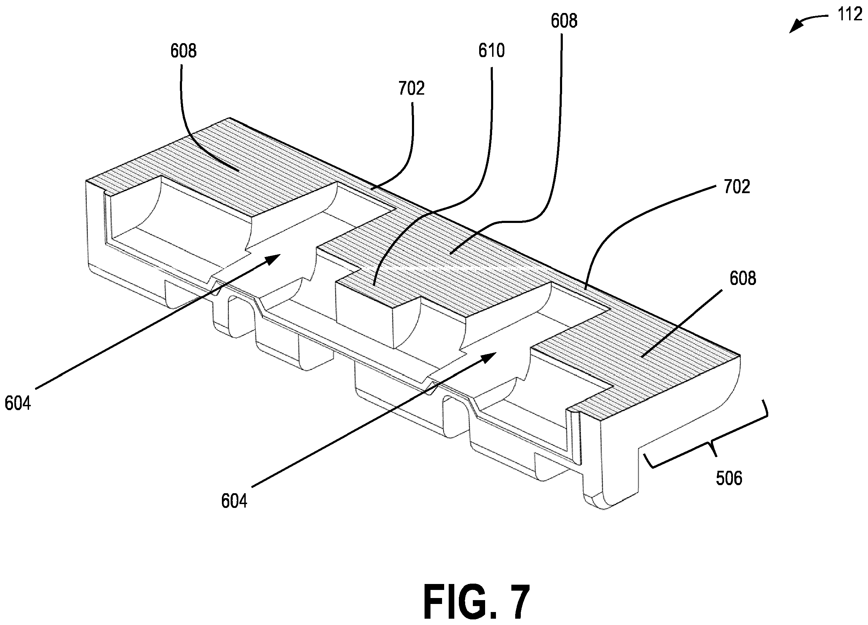

With reference to FIG. 6 and FIG. 7, further aspects of the resilient spring member 112 are described.

In embodiments, the resilient spring member 112 can include one or more surfaces 602 having one or more hollow cavities 604 disposed therein. In some embodiments, the one or more hollow cavities 604 may be disposed within a recess 606, also defined within the one or more surfaces 602. The recess 606 of the resilient spring member 112 may include one or more solid sections 608 between and/or adjacent to each of the hollow cavities 604. In particular embodiments, each of the solid sections 608 may be adjacent to at least one of the one or more conductive strips 400 of the flexible circuit 104. Each of the solid sections 608 may be tuned to balance the otherwise unequal battery forces that are present due to the linear distribution of the batteries. In other words, the solid sections 608 can be configured to provide customized counterbalancing forces that help secure each battery within the receiving area 106.

In the examples of FIG. 5 and FIG. 6, the resilient spring member 112 includes a recess 606 having two cavities 604 with adjacent solid sections 608 on either side of the cavities 604 such that each solid section 608 is adjacent to a corresponding conductive strip 400. Put another way, each of the hollow cavities 604 of the resilient spring member 112 may be adjacent to a non-conductive section 405 of the flexible circuit 104.

With reference to FIG. 6 and FIG. 7, each of the one or more hollow cavities 604 of the resilient spring member 112 may form a thinned section 702 of the resilient spring member 112 that is adjacent to the non-conductive sections 405 of the flexible circuit 104. In further embodiments, the resilient spring member 112 may also include one or more reinforced sections 610 within the recess 606. In embodiments, each of the one or more reinforced sections 610 may be tuned to balance the otherwise unequal battery forces that are present due to the linear distribution of the batteries. In other words, the reinforced section(s) 610 can be configured to provide customized counterbalancing forces that help secure each battery within the receiving area 106.

In the example of FIG. 7, the reinforced section 610 includes additional material in excess of the solid sections 608. In particular embodiments, each reinforced section 610 may be disposed adjacent to at least one of the one or more conductive strips 400 of the flexible circuit 104. In embodiments, each reinforced section 610 is disposed between two adjacent hollow cavities 604.

In embodiments, the surface 602 of the resilient spring member 112 also includes a sealing bead 612 that extends outwardly from the surface 602. The sealing bead 612 can be configured to circumscribe or otherwise create a perimeter around one or more of the hollow cavities 604 and the recess 606 of the resilient spring member 112. For example, as shown in FIG. 6, the resilient spring member 112 includes a first set of two hollow cavities 604 circumscribed by a first sealing bead 612.

In embodiments, the resilient spring member 112 may be secured between the sidewall 118A of the compartment casing 102 and the exterior surface 504 of the flexible circuit 104, and the one or more cavities 604 and/or recess 606 may include a concave surface defining an open volume (i.e., an air chamber) between the sidewall 118A and the resilient spring member 112. In further embodiments, the sealing bead 612 of the resilient spring member 112 can be configured to provide a continuous contact with an interior surface (surface 132 shown in FIG. 2A) of the sidewall 118A of the compartment casing 102 such that fluid and/or debris cannot become trapped within the air chamber formed therein. Accordingly, when assembled, the sealing bead 612, solid sections 608, the hollow cavities 604, and reinforced sections 610 of the resilient spring member 112 may form one or more air chambers with the sidewall 118A of the compartment casing 102.

In embodiments, one or more of the portions of the resilient spring member 112 may comprise a flexible and/or compressible material, such as silicone, and may be formed through a process such as injection molding. In particular embodiments, at least one of the rib portion 506 and the reinforced sections 610 of the resilient spring member 112 are formed from a flexible and/or compressible material such as silicone.

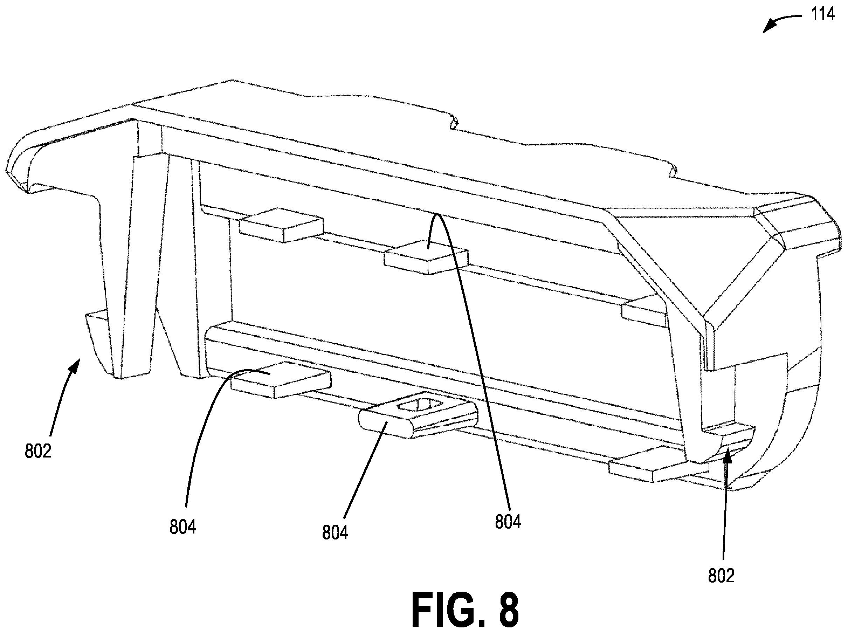

In embodiments, the resilient spring member 112 may be secured between the sidewall 118A of the compartment casing 102 and the exterior surface 504 of the flexible circuit 104 via a shroud member 114. Put another way, the resilient spring member 112 and the folded section 306 of the flexible circuit 104 may be secured to the compartment casing 102 via the shroud member 114. With reference to FIG. 8, for example, the shroud member 114 can include one or more fastening features 802, 804 configured to join or mate with one or more complementary slots provided in the compartment casing 102.

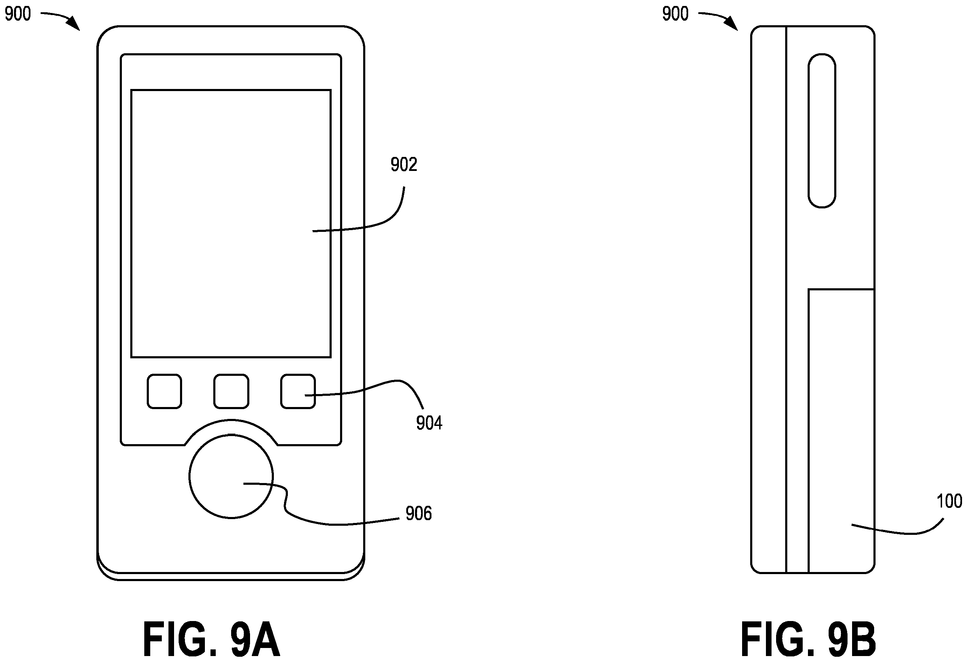

Also provided herein are battery-powered patient monitors, including but not limited to, worn patient monitors. For example, with reference to FIG. 9A and FIG. 9B, a worn patient monitor 900 is illustrated in a front plan view and side plan view, respectively, according to aspects of the present disclosure. In embodiments, the patient monitor 900 may include a battery compartment assembly 100 configured to receive one or more removeable batteries and to provide one or more battery contacts (e.g., contacts 301) that facilitate the supply of power from the removable batteries to the patient monitor 900. In particular embodiments, the battery compartment assembly 100 includes one or more hollow cavities 604, recesses 606, reinforced sections 610, and/or air chambers as described herein.

In further embodiments, the battery compartment assembly 100 may be hinged at one of the sidewalls 118A, 118B, 118C, 118D of the compartment casing 102 such that the battery compartment assembly 100 can be rotated relative to the rest of the patient monitor 900 about a fixed axis. For example, as shown in FIG. 2A and FIG. 2B, the exterior surfaces of the sidewalls 118A, 118D include protrusions 130 to engage the housing of the patient monitor 900 and enable the battery compartment assembly 100 to open, thereby allowing any batteries to be inserted, removed, and/or replaced.

In exemplary embodiments, the patient monitor 900 can include one or more electronic components requiring power, including but not limited to, one or more display screens 902 (e.g., a liquid crystal display (LCD), a thin film transistor-liquid crystal display (TFT-LCD), an organic light-emitting diode display (OLED), a flexible display, a three-dimensional display, a touch screen, and/or the like), one or more touch-capacitive buttons 904, one or more tactile buttons 906 (e.g., push button, rocker, slide, and/or the like), a controller or microcontroller (not shown) configured to operate the patient monitor 900 and communicate with other devices, and one or more sensors (not shown) operatively connected to the patient monitor 900, among other components.

It should be appreciated that all combinations of the foregoing concepts and additional concepts discussed in greater detail below (provided such concepts are not mutually inconsistent) are contemplated as being part of the inventive subject matter disclosed herein. In particular, all combinations of claimed subject matter appearing at the end of this disclosure are contemplated as being part of the inventive subject matter disclosed herein. It should also be appreciated that terminology explicitly employed herein that also may appear in any disclosure incorporated by reference should be accorded a meaning most consistent with the particular concepts disclosed herein.

All definitions, as defined and used herein, should be understood to control over dictionary definitions, definitions in documents incorporated by reference, and/or ordinary meanings of the defined terms.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e. "one or the other but not both") when preceded by terms of exclusivity, such as "either," "one of," "only one of," or "exactly one of."

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

As used herein, although the terms first, second, third, etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

Unless otherwise noted, when an element or component is said to be "connected to," "coupled to," or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" to another element or component, this encompasses only cases where the two elements or components are connected to each other without any intermediate or intervening elements or components.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of" and "consisting essentially of" shall be closed or semi-closed transitional phrases, respectively.

The invention is defined in the appended claims.

## Claims

1. A battery compartment assembly (100) comprising:
a compartment casing (102) having one or more sidewalls (118A, 118B, 118C, 118D) that define a receiving area (116) sized to receive one or more removable batteries;
a flexible circuit (104) disposed within the receiving area of the compartment casing and having a folded section (304, 306, 208) that is folded at a first sidewall and within the receiving area of the compartment casing, wherein the flexible circuit further comprises one or more conductive strips (400) disposed on the folded section of the flexible circuit; and
a resilient spring member (112) disposed between the first sidewall of the compartment casing and the flexible circuit, the resilient spring member comprising one or more hollow cavities (604) offset from each of the one or more conductive strips of the flexible circuit, wherein each hollow cavity is defined between the resilient spring member and the first sidewall of the compartment casing.

2. The battery compartment assembly of claim 1, wherein each of the one or more conductive strips of the folded section of the flexible circuit provides a battery contact corresponding to one of the removable batteries.

3. The battery compartment assembly of claim 1, wherein the resilient spring member comprises a recess (606) and a sealing bead (612) circumscribing the recess, the recess being defined between the resilient spring member and the first sidewall of the compartment casing, and the sealing bead being configured to provide a continuous contact with an interior surface (132) of the first sidewall of the compartment casing.

4. The battery compartment assembly of claim 3, wherein the one or more hollow cavities are disposed within the recess of the resilient spring member.

5. The battery compartment assembly of claim 3, wherein the resilient spring member comprises a reinforced section (610) within the recess adjacent to at least one of the one or more conductive strips of the flexible circuit.

6. The battery compartment assembly of claim 3, wherein the sealing bead, the resilient spring member, and the first sidewall of the compartment casing form an air chamber adjacent to the interior surface of the first sidewall.

7. The battery compartment assembly of claim 1, wherein the flexible circuit comprises a non-conductive section (405) between each conductive strip of the flexible circuit, each non-conductive section having a width of at least about 2.0 millimeters.

8. The battery compartment assembly of claim 7, wherein each hollow cavity of the resilient spring member is adjacent to a non-conductive section of the flexible circuit.

9. The battery compartment assembly of claim 7, wherein each non-conductive section of the flexible circuit comprises a non-conductive composition.

10. The battery compartment assembly of claim 9, wherein each non-conductive section of the flexible circuit comprises a polyamide polymer.

11. The battery compartment assembly of claim 1, wherein each hollow cavity of the resilient spring member has a concave surface defining the hollow cavity.

12. The battery compartment assembly of claim 1, wherein the resilient spring member is secured between the first sidewall of the compartment casing and the folded section of the flexible circuit by a shroud member 114.

13. The battery compartment assembly of claim 12, wherein the shroud member comprises one or more latches configured to join the shroud member to the flexible circuit, the resilient spring member, and the compartment casing.

14. The battery compartment assembly of claim 1, wherein the compartment casing is formed from a rigid material, and the resilient spring member is formed from at least a compressible polymer.

15. A worn patient monitor (900) comprising a battery compartment assembly (100), according to claim 1, the
battery compartment assembly providing one or more battery contacts configured to interface with electrical terminals of one or more removable batteries, wherein the battery compartment assembly comprises:
a compartment casing (102) having one or more sidewalls (118A, 118B, 118C, 118D) that define a receiving area (116) sized to receive one or more removable batteries;
a flexible circuit (104) disposed within the receiving area of the compartment casing and having a folded section (304, 306, 208) that is folded at a first sidewall and within the receiving area of the compartment casing, wherein the flexible circuit further comprises one or more conductive strips (400) disposed on the folded section of the flexible circuit; and
a resilient spring member (112) disposed between the first sidewall of the compartment casing and the flexible circuit, the resilient spring member comprising one or more hollow cavities (604) offset from each of the one or more conductive strips of the flexible circuit, wherein each hollow cavity is defined between the resilient spring member and the first sidewall of the compartment casing.

## Patentansprüche

1. Batteriefachanordnung (100), umfassend:
ein Fachgehäuse (102), das eine oder mehrere Seitenwände (118A, 118B, 118C, 118D) aufweist, die einen Aufnahmebereich (116) definieren, der so dimensioniert ist, dass er eine oder mehrere entfernbare Batterien aufnimmt;
eine flexible Schaltung (104), die innerhalb des Aufnahmebereichs des Fachgehäuses angeordnet ist und einen gefalteten Abschnitt (304, 306, 208) aufweist, der an einer ersten Seitenwand und innerhalb des Aufnahmebereichs des Fachgehäuses gefaltet ist, wobei die flexible Schaltung weiter einen oder mehrere leitfähige Streifen (400) umfasst, die in dem gefalteten Abschnitt der flexiblen Schaltung angeordnet sind; und
ein elastisches Federelement (112), das zwischen der ersten Seitenwand des Fachgehäuses und der flexiblen Schaltung angeordnet ist, wobei das elastische Federelement einen oder mehrere Hohlräume (604) umfasst, von jedem des einen oder der mehreren leitfähigen Streifen der flexiblen Schaltung versetzt sind, wobei jeder Hohlraum zwischen dem elastischen Federelement und der ersten Seitenwand des Fachgehäuses definiert ist.

2. Batteriefachanordnung nach Anspruch 1, wobei jeder der einen oder mehreren leitfähigen Streifen des gefalteten Abschnitts der flexiblen Schaltung einen Batteriekontakt bereitstellt, der einer der entfernbaren Batterien entspricht.

3. Batteriefachanordnung nach Anspruch 1, wobei das elastische Federelement des Aufnahmebereichs eine Aussparung (606) und eine Dichtungswulst (612) umfasst, die Aussparung umschließt, wobei die Aussparung zwischen dem elastischen Federelement und der ersten Seitenwand des Fachgehäuses definiert ist und die Dichtungswulst so konfiguriert ist, dass sie einen kontinuierlichen Kontakt mit einer Innenfläche (132) der ersten Seitenwand des Fachgehäuses bereitstellt.

4. Batteriefachanordnung nach Anspruch 3, wobei der eine oder die mehreren Hohlräume innerhalb der Aussparung des elastischen Federelements angeordnet sind.

5. Batteriefachanordnung nach Anspruch 3, wobei das elastische Federelement einen verstärkten Abschnitt (610) innerhalb der Aussparung aufweist, der an mindestens einen des einen oder der mehreren leitfähigen Streifen der flexiblen Schaltung angrenzend ist.

6. Batteriefachanordnung nach Anspruch 3, wobei die Dichtungswulst, das elastische Federelement und die erste Seitenwand des Fachgehäuses eine Luftkammer bilden, die an die Innenfläche der ersten Seitenwand angrenzend ist.

7. Batteriefachanordnung nach Anspruch 1, wobei die flexible Schaltung zwischen jedem leitfähigen Streifen der flexiblen Schaltung einen nichtleitenden Abschnitt (405) umfasst, wobei jeder nichtleitende Abschnitt eine Breite von mindestens etwa 2,0 Millimetern aufweist.

8. Batteriefachanordnung nach Anspruch 7, wobei jeder Hohlraum des elastischen Federelements an einen nichtleitenden Abschnitt der flexiblen Schaltung angrenzend ist.

9. Batteriefachanordnung nach Anspruch 7, wobei jeder nichtleitende Abschnitt der flexiblen Schaltung eine nichtleitende Zusammensetzung umfasst.

10. Batteriefachanordnung nach Anspruch 9, wobei jeder nichtleitende Abschnitt der flexiblen Schaltung ein Polyamidpolymer umfasst.

11. Batteriefachanordnung nach Anspruch 1, wobei jeder Hohlraum des elastischen Federelements eine konkave Oberfläche aufweist, die den Hohlraum definiert.

12. Batteriefachanordnung nach Anspruch 1, wobei das elastische Federelement zwischen der ersten Seitenwand des Fachgehäuses und dem gefalteten Abschnitt der flexiblen Schaltung durch ein Abdeckelement 114 befestigt ist.

13. Batteriefachanordnung nach Anspruch 12, wobei das Abdeckelement einen oder mehrere Klinken umfasst, die so konfiguriert sind, dass sie das Abdeckelement mit der flexiblen Schaltung, dem elastischen Federelement und dem Fachgehäuse verbinden.

14. Batteriefachanordnung nach Anspruch 1, wobei das elastische Federelement aus einem starren Material gebildet ist und das elastische Federelement aus mindestens einem komprimierbaren Polymer gebildet ist.

15. Am Körper getragener Patientenmonitor (900), der eine Batteriefachanordnung (100) nach Anspruch 1 umfasst, wobei die Batteriefachanordnung einen oder mehrere Batteriekontakte bereitstellt, die so konfiguriert sind, dass mit den elektrischen Anschlüssen der einen oder der mehreren entfernbaren Batterien verbinden, wobei die Batteriefachanordnung Folgendes umfasst:
ein Fachgehäuse (102), das eine oder mehrere Seitenwände (118A, 118B, 118C, 118D) aufweist, die einen Aufnahmebereich (116) definieren, der so dimensioniert ist, dass er eine oder mehrere entfernbare Batterien aufnimmt;
eine flexible Schaltung (104), die innerhalb des Aufnahmebereichs des Fachgehäuses angeordnet ist und einen gefalteten Abschnitt (304, 306, 208) aufweist, der an einer ersten Seitenwand und innerhalb des Aufnahmebereichs des Fachgehäuses gefaltet ist, wobei die flexible Schaltung weiter einen oder mehrere leitfähige Streifen (400) umfasst, die in dem gefalteten Abschnitt der flexiblen Schaltung angeordnet sind; und
ein elastisches Federelement (112), das zwischen der ersten Seitenwand des Fachgehäuses und der flexiblen Schaltung angeordnet ist, wobei das elastische Federelement einen oder mehrere Hohlräume (604) umfasst, von jedem des einen oder der mehreren leitfähigen Streifen der flexiblen Schaltung versetzt sind, wobei jeder Hohlraum zwischen dem elastischen Federelement und der ersten Seitenwand des Fachgehäuses definiert ist.

## Revendications

1. Ensemble de compartiment de batterie (100), comprenant :
un boîtier de compartiment (102) présentant une ou plusieurs parois latérales (118A, 118B, 118C, 118D) qui définissent une zone de réception (116) dimensionnée pour recevoir une ou plusieurs batteries amovibles ;
un circuit flexible (104) disposé au sein de la zone de réception du boîtier de compartiment et présentant une section pliée (304, 306, 208) qui est pliée au niveau d'au moins une première paroi latérale et à l'intérieur de la zone de réception du boîtier de compartiment, dans lequel le circuit flexible comprend en outre une ou plusieurs bandes conductrices (400) disposées dans la section pliée du circuit flexible ; et
un organe de ressort élastique (112) disposé entre la première paroi latérale du boîtier de compartiment et le circuit flexible, l'organe de ressort élastique comprenant une ou plusieurs cavités creuses (604) décalées par rapport à chacune des un ou plusieurs bandes conductrices du circuit flexible, dans lequel chaque cavité creuse est définie entre l'organe de ressort élastique et la première paroi latérale du boîtier de compartiment.

2. Ensemble du compartiment de batterie selon la revendication 1, dans lequel chacune des une ou plusieurs bandes conductrices de la section pliée du circuit flexible fournit un contact de batterie correspondant à l'une des batteries amovibles.

3. Ensemble de compartiment de batterie selon la revendication 1, dans lequel l'organe de ressort élastique comprend un évidement (606) et un joint d'étanchéité (612) circonscrivant l'évidement, l'évidement étant défini entre l'organe de ressort élastique et la première paroi latérale du boîtier de compartiment, et le joint d'étanchéité étant configuré pour fournir un contact continu avec une surface intérieure (132) de la première paroi latérale du boîtier de compartiment.

4. Ensemble de compartiment de batterie selon la revendication 3, dans lequel les une ou plusieurs cavités creuses sont disposées dans l'évidement de l'organe de ressort élastique.

5. Ensemble de compartiment de batterie selon la revendication 3, dans lequel l'organe de ressort élastique comprend une section renforcée (610) dans l'évidement adjacent à au moins l'une des une ou plusieurs bandes conductrices du circuit flexible.

6. Ensemble de compartiment de batterie selon la revendication 3, dans lequel le joint d'étanchéité, l'organe de ressort élastique et la première paroi latérale du boîtier de compartiment forment une chambre à air adjacente à la surface intérieure de la première paroi latérale.

7. Ensemble de compartiment de batterie selon la revendication 1, dans lequel le circuit flexible comprend une section non conductrice (405) entre chaque bande conductrice du circuit flexible, chaque section non conductrice présentant une largeur d'au moins environ 2,0 millimètres.

8. Ensemble de compartiment de batterie selon la revendication 7, dans lequel chaque cavité creuse de l'organe de ressort élastique est adjacente à une section non conductrice du circuit flexible.

9. Ensemble de compartiment de batterie selon la revendication 7, dans lequel chaque section non conductrice du circuit flexible comprend une composition non conductrice.

10. Ensemble de compartiment de batterie selon la revendication 9, dans lequel chaque section non conductrice du circuit flexible comprend un polymère polyamide.

11. Ensemble de compartiment de batterie selon la revendication 1, dans lequel chaque cavité creuse de l'organe de ressort élastique présente une surface concave définissant la cavité creuse.

12. Ensemble de compartiment de batterie selon la revendication 1, dans lequel l'organe de ressort élastique est fixé entre la première paroi latérale du boîtier de compartiment et la section pliée du circuit flexible par un organe d'épaulement (114).

13. Ensemble de compartiment de batterie selon la revendication 12, dans lequel l'organe d'épaulement comprend un ou plusieurs loquets configurés pour joindre l'organe d'épaulement au circuit flexible, à l'organe de ressort élastique et au boîtier de compartiment.

14. Ensemble de compartiment de batterie selon la revendication 1, dans lequel le boîtier de compartiment est formé à partir d'un matériau rigide, et l'organe de ressort élastique est formé à partir d'au moins un polymère compressible.

15. Moniteur de patient porté (900) comprenant un ensemble de compartiment de batterie (100) selon la revendication 1, l'ensemble de compartiment de batterie fournissant un ou plusieurs contacts d'alimentation configurés pour s'interfacer avec des bornes électriques d'une ou de plusieurs batteries amovibles, dans lequel l'ensemble de compartiment de batterie comprend :
un boîtier de compartiment (102) présentant une ou plusieurs parois latérales (118A, 118B, 118C, 118D) qui définissent une zone de réception (116) dimensionnée pour recevoir une ou plusieurs batteries amovibles ;
un circuit flexible (104) disposé au sein de la zone de réception du boîtier de compartiment et présentant une section pliée (304, 306, 208) qui est pliée au niveau d'au moins une première paroi latérale et à l'intérieur de la zone de réception du boîtier de compartiment, dans lequel le circuit flexible comprend en outre une ou plusieurs bandes conductrices (400) disposées dans la section pliée du circuit flexible ; et
un organe de ressort élastique (112) disposé entre la première paroi latérale du boîtier de compartiment et le circuit flexible, l'organe de ressort élastique comprenant une ou plusieurs cavités creuses (604) décalées par rapport à chacune des un ou plusieurs bandes conductrices du circuit flexible, dans lequel chaque cavité creuse est définie entre l'organe de ressort élastique et la première paroi latérale du boîtier de compartiment.
